# EUROPÄISCHE PATENTSCHRIFT

(11) **EP 2 044 823 B1**
(45) Veröffentlichungstag und Bekanntmachung des Hinweises auf die Patenterteilung: **17.02.2010**
(21) Anmeldenummer: 07729110.2
(22) Anmeldetag: 14.05.2007
(51) Int. Cl.: H05K 7/20, F04D 29/42

(54) **ANORDNUNG ZUR KLIMATISIERUNG VON BAUGRUPPEN**
ARRANGEMENT FOR THE AIR CONDITIONING OF SUBASSEMBLIES
AGENCEMENT POUR LA CLIMATISATION DE MODULES

(30) Priorität: 24.07.2006 DE 102006034156
(43) Veröffentlichungstag der Anmeldung: 08.04.2009
(73) Patentinhaber: SIEMENS AKTIENGESELLSCHAFT, 80333 München (DE)
(72) Erfinder: KRAUS, Harald, 89415 Lauingen (DE)
(86) Internationale Anmeldenummer: PCT/EP2007/054658
(87) Internationale Veröffentlichungsnummer: WO 2008/012119

(56) Entgegenhaltungen:
- EP-A- 1 657 447
- DE-A1- 19 956 038

## Beschreibung

Die Erfindung betrifft eine Anordnung zur Klimatisierung von Baugruppen, insbesondere von elektrischen Baugruppen, in einem abgeschlossenen Gehäuse.

Es sind Klimakonzepte zur Belüftung bzw. Klimatisierung von elektrischen Baugruppen in Basisstationen bekannt, bei denen Lüfter verwendet werden.

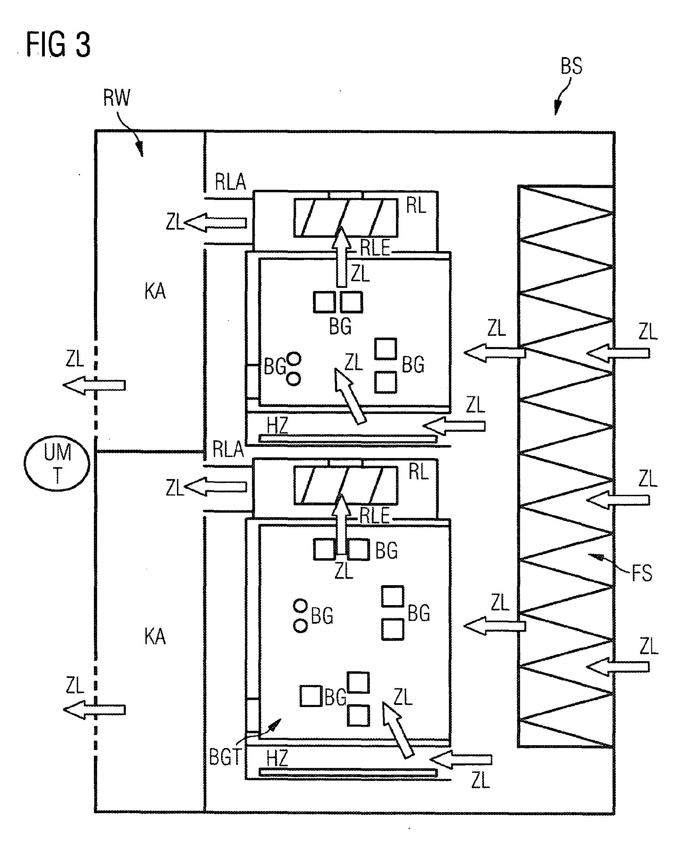

FIG 3 zeigt anhand einer Mobilfunk-Basisstation beispielhaft ein erstes Klimakonzept gemäß dem Stand der Technik.

Bei diesem Klimakonzept wird ein Radiallüfter RL als Lüfter verwendet.

Elektrische Baugruppen BG, die je nach Umgebungstemperatur T gekühlt oder gewärmt werden sollen, sind auf einem Baugruppenträger BGT im Inneren eines Basisstationsgehäuses BS angeordnet.

Mit Hilfe des Radiallüfters RL wird Luft ZL als Zuluft über ein Filtersystem FS in das Innere des Basisstationsgehäuses BS gesaugt.

Das Filtersystem FS verhindert dabei ein unerwünschtes Eindringen von Staub und Schadstoffpartikeln. Dies ist notwendig, weil Luftfeuchtigkeit in Verbindung mit den Schadstoffpartikeln innerhalb des Basisstationsgehäuses BS Korrosion verursachen würde.

Die Luft ZL gelangt über eine zuschaltbare Heizung HZ zu den Baugruppen BG und kann somit sowohl zur Kühlung als auch zur Erwärmung der Baugruppen BG verwendet werden. Die zur Klimatisierung der Baugruppen BG verwendete Luft ZL wird dann über einen Eingang RLE des Radiallüfters RL in das Innere des Radiallüfters RL geführt.

Das Basisstationsgehäuse BS weist eine in Kammern KA unterteilte, so genannte "Standard"-Rückwand RW auf. Diese Rückwand RW ist derart ausgebildet, dass die zur Klimatisierung verwendete Luft ZL aus dem Inneren des Basisstationsgehäuses BS über einen Ausgang RLA des Radiallüfters RL in eine Kammer KA der Rückwand RW gelangt.

Die Kammer KA wiederum ist mit der Umgebung UM verbunden, so dass die zur Klimatisierung verwendete Luft ZL das Basisstationsgehäuse BS als Abluft in die Umgebung UM geführt wird.

Bei Umgebungstemperaturen T von üblicherweise T < 0° Celsius wird die Luft ZL über die Heizung HZ erwärmt, um ausgewählte Baugruppen BG entsprechend erwärmen zu können. Zu diesem Zweck sind im Inneren des Basisstationsgehäuses BS in der Nähe der Baugruppen BG jeweils zugeordnete, voneinander unabhängig steuerbare, elektrische Heizungen HZ vorgesehen.

Bei diesem Klimakonzept entstehen im Betrieb zusätzliche Kosten durch die benötigte elektrische Heizenergie.

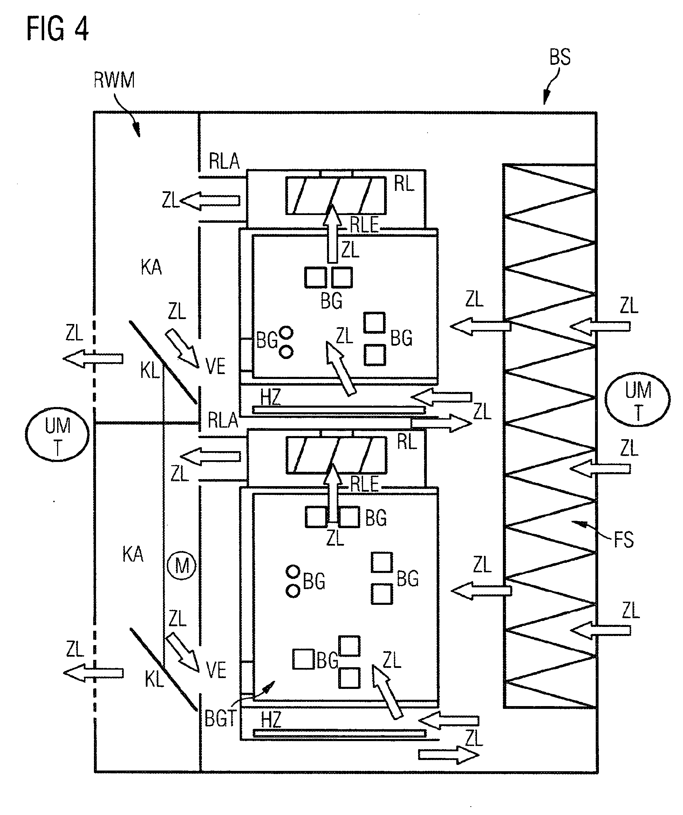

FIG 4 zeigt anhand einer Mobilfunk-Basisstation beispielhaft ein zweites Klimakonzept gemäß dem Stand der Technik. Auch hier wird wieder ein Radiallüfter RL als Lüfter verwendet.

Im Vergleich zu der in FIG 3 beschriebenen Ausgestaltungsform wird hier eine modifizierte Rückwand RWM verwendet, die ebenfalls in Kammern KA unterteilt ist.

Jede Kammer KA weist eine weitere Öffnung bzw. Verbindung VE auf, die mit einer Klappe KL steuerbar verschlossen werden kann. Die Klappe KL verbindet die Kammer KA mit dem Inneren des Basisstationsgehäuses BS.

Durch die Klappe KL ist es möglich, von den Baugruppen BG in einem ersten Durchlauf bereits erwärmte Luft aus der Kammer KA zurück ins Innere des Basisstationsgehäuses BS zu leiten und diese in einem zweiten Durchlauf zur erneuten Erwärmung der Baugruppen BG zu verwenden.

Mit anderen Worten wird zur Klimatisierung verwendete Luft ZL einem Kreislauf unterworfen:
- eingesaugte Luft ZL gelangt über die Baugruppen BG und den jeweils zugeordneten Heizungen HZ zum Radiallüfter RL,
- über den Ausgang RLA des Radiallüfters RL gelangt die Luft in jeweilige Kammern KA der Rückwand RWM,
- Luft aus der Kammern KA kann dann - gesteuert über die Klappe KL - erneut zur Klimatisierung der Baugruppen BG verwendet werden und/oder in die Umgebung UM abgeleitet werden.

Durch die Klappen KL und die Kammern KA und die damit steuerbare Luftzirkulation wird der Bedarf an elektrischer Heizenergie verringert. Zusätzlich kann im Inneren des Basisstationsgehäuses BS eine Absenkung der relativen Luftfeuchtigkeit erzielt werden.

Die steuerbaren Klappen KL werden über elektrische Motoren M angetrieben, wobei diese über ein so genanntes "Controller Board" gesteuert werden. Das "Controller Board" steuert die Klimatisierung im Inneren des Basisstationsgehäuses BS bzw. die Klimatisierung der Baugruppen BG mit Hilfe von hier nicht näher dargestellten Sensoren.

Dieses zweite Klimakonzept erlaubt jedoch im allgemeinen keine Nachrüstung bei bereits bestehenden, betriebenen Basisstationsgehäusen. Meist ist es nicht möglich, die Rückwand des Basisstationsgehäuses gegen eine modifizierte Rückwand der vorstehend beschriebenen Art auszutauschen.

Es ist Aufgabe der vorliegenden Erfindung, eine Anordnung zur Klimatisierung von Baugruppen in einem Gehäuse anzugeben, wobei diese Anordnung mit geringem Aufwand auch in bereits existierenden Gehäusen bzw. Basisstationsgehäusen nachträglich realisierbar sein soll.

Diese Aufgabe wird durch die Merkmale des Patentanspruchs 1 gelöst. Vorteilhafte Weiterbildungen sind in den Unteransprüchen angegeben.

Bei der erfindungsgemäßen Anordnung zur Klimatisierung von Baugruppen in einem abgeschlossenen Gehäuse sind die Baugruppen im Inneren des Gehäuses angeordnet. Das Gehäuse weist einen Lufteinlass auf, über den Luft zur Klimatisierung ins Innere des Gehäuses geführt wird. Das Gehäuse beinhaltet einen Lüfter, über den die zur Klimatisierung der Baugruppen verwendete Luft aus dem Inneren des Gehäuses nach außen geführt wird. Der Lüfter weist neben einem Lüftereingang zumindest zwei Lüfterausgänge auf. Im Inneren des Lüfters ist eine drehbar gelagerte Blende angeordnet, durch deren variabel einstellbare Position die über den Lüftereingang eingesaugte Luft wahlweise über zumindest einen der Lüfterausgänge geführt wird.

Durch die erfindungsgemäße Anordnung kann ein nachträglicher Austausch einer Rückwand eines Basisstationsgehäuses entfallen. Zur Nachrüstung ist es lediglich notwendig, den bevorzugt als Radiallüfter ausgestalteten Lüfter gegen einen modifizierten Lüfter mit Blende auszutauschen.

Für den Fall einer Nachrüstung ist ein Austausch des im Basisstationsgehäuse angeordneten "Controller Board" im allgemeinen leicht möglich.

Der erfindungsgemäß verwendete Lüfter beinhaltet in seinem Gehäuse eine drehbar gelagerte Blende sowie eine Einrichtung zum drehen der Blende.

Durch den erfindungsgemäß gestalteten Lüfter mit Blende ist es möglich, Ausblasrichtungen zwischen einer ersten Ausblasrichtung (z.B. nach außen in die Umgebung) und einer zweiten Ausblasrichtung (z.B. zurück ins Innere des Basisstationsgehäuses) variabel einzustellen.

Durch die erfindungsgemäß im Lüfter bzw. Radiallüfter integrierte, drehbar gelagerte Blende kann zwischen zwei oder mehreren definierten Ausblasrichtungen gewählt werden.

Die Blende ist vorteilhafterweise drehbar um die Lüfter-Längsachse gelagert. Die Blende wird mit Hilfe eines Stellmotor oder einer von Hand einstellbaren Antriebsmechanik variabel gedreht bzw. eingestellt.

Mit Hilfe einer im Lüfter integrierten Schnittstelle ist es möglich, den Stellmotor ebenfalls über das "Controller Board" anzusteuern.

Bei Ausfall des Antriebs wird die Blende mit Hilfe von Federkraft derart positioniert, dass eine bevorzugte Ausblasrichtung eingestellt wird.

Nachfolgend wird die Erfindung anhand einer Zeichnung näher erläutert. Dabei zeigt:
- FIG 1: eine Ausgestaltung der erfindungsgemäße Anordnung zur Klimatisierung von Baugruppen anhand eines beispielhaften Basisstationsgehäuses,
- FIG 2: Darstellungen eines Radiallüfters zur Verwendung bei der erfindungsgemäßen Anordnung,
- FIG 3: das eingangs beschriebene, beispielhafte erste Klimakonzept gemäß dem Stand der Technik, und
- FIG 4: das eingangs beschriebene, beispielhafte zweite Klimakonzept gemäß dem Stand der Technik.

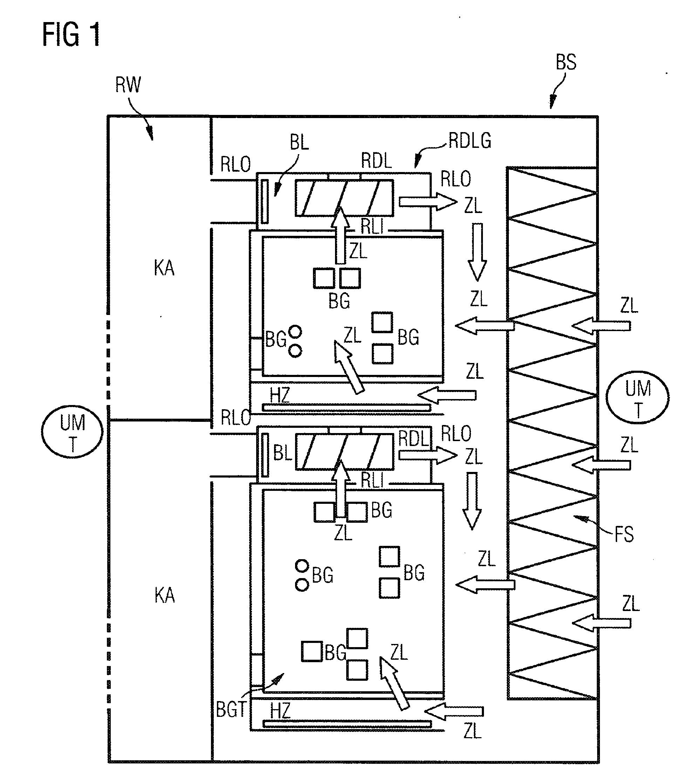

FIG 1 zeigt eine Ausgestaltung der erfindungsgemäßen Anordnung zur Klimatisierung von Baugruppen BG anhand eines beispielhaften Basisstationsgehäuses BS.

Dabei wird ein modifizierter Radiallüfter RDL als Lüfter verwendet.

Elektrische Baugruppen BG, die je nach Umgebungstemperatur T gekühlt oder geheizt werden sollen, sind auf einem Baugruppenträger BGT im Inneren des Basisstationsgehäuses BS angeordnet.

Mit Hilfe des Radiallüfters RDL wird Luft ZL als Zuluft über ein Filtersystem FS in das Innere des Basisstationsgehäuses BS gesaugt.

Das Filtersystem FS verhindert dabei ein unerwünschtes Eindringen von Staub und Schadstoffpartikel. Dies ist notwendig, weil Luftfeuchtigkeit in Verbindung mit den Schadstoffpartikeln innerhalb des Basisstationsgehäuses BS Korrosion verursachen würde.

Die Luft ZL gelangt über eine zuschaltbare Heizung HZ zu den Baugruppen BG und kann somit sowohl zur Kühlung als auch zur Erwärmung bzw. Heizung der Baugruppen BG verwendet werden. Die zur Klimatisierung der Baugruppen BG verwendete Luft ZL wird dann über einen Eingang RLI in das Innere des Radiallüfters RDL geführt.

Das Basisstationsgehäuse BS weist eine in Kammern KA unterteilte Rückwand RW auf. Diese Rückwand RW ist derart ausgebildet, dass die zur Klimatisierung verwendete Luft ZL über einen Ausgang RLO des Radiallüfters RDL in eine Kammer KA der Rückwand RW gelangen kann. Die Kammer KA wiederum ist mit der Umgebung UM des Basisstationsgehäuses BS verbunden, so dass die zur Klimatisierung verwendete Luft ZL das Basisstationsgehäuse BS als Abluft verlassen kann.

Bei Umgebungstemperaturen T < 0° Celsius wird die Luft ZL über die Heizeinrichtung HZ erwärmt, um eine Anzahl an Baugruppen BG entsprechend erwärmen zu können.

Der modifizierte Radiallüfter RDL beinhaltet in seinem Inneren bzw. im Radiallüfter-Gehäuse RDLG eine um dessen Längsachse drehbar gelagerte Blende BL, die nachfolgend näher beschrieben wird.

Die Blende BL kann dabei entweder zumindest eine Öffnung aufweisen, so dass je nach Ausrichtung der Blende BL bzw. deren Öffnung die Luft ins Innere des Basisstationsgeriäuses BS und/oder in die Kammer KA der Rückwand RW über jeweilige Ausgänge RLO geblasen werden kann.

Alternativ dazu kann die Blende BL als Verschlussblech ohne Öffnungen realisiert sein, deren beide Enden zusammen mit Öffnungen des die Blende BL umgebenden Radiallüfter-Gehäuses RDLG zumindest eine Ausblasrichtung festlegt.

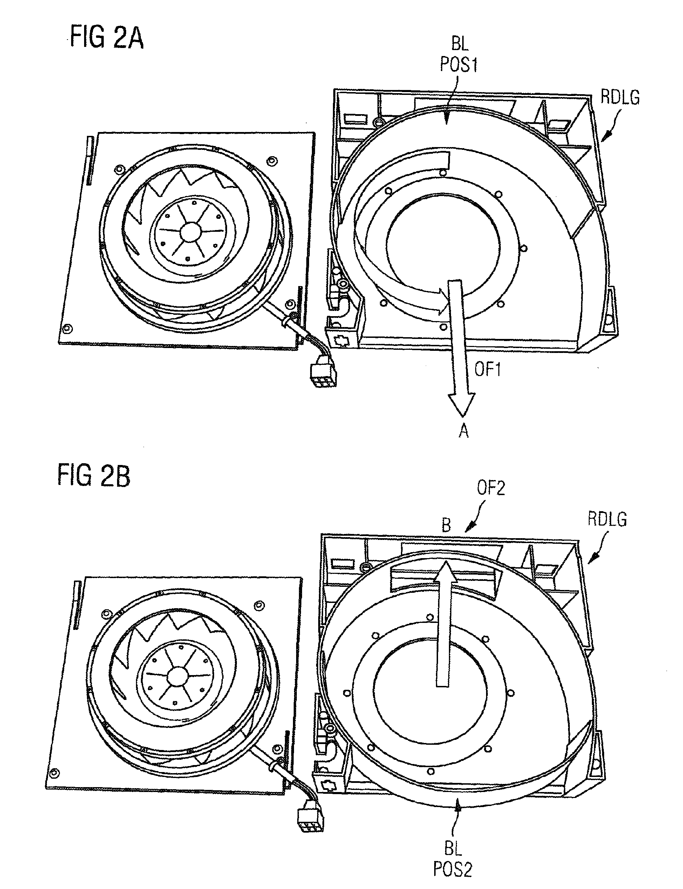

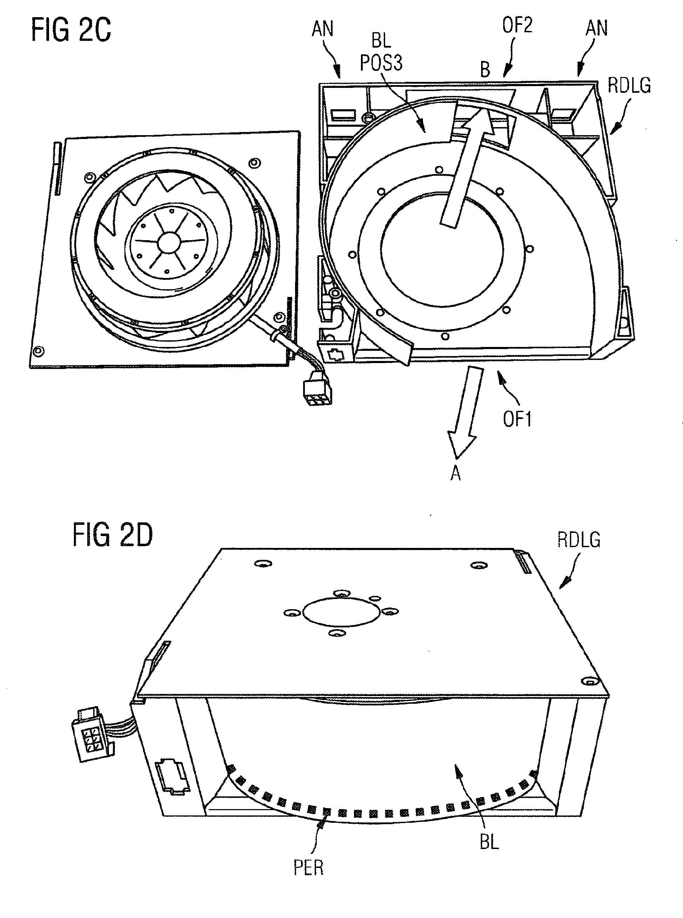

FIG 2 zeigt in vier Darstellungen den modifizierten Radiallüfter, der bei der erfindungsgemäßen Anordnung verwendet wird.

FIG 2A zeigt die drehbar gelagerte Blende BL, die als Verschlussblech realisiert ist, in einer ersten Position POS1. In dieser ersten Position POS1 erfolgt ein Ausblasen der Luft, die dem Radiallüfter RDL zugeführt wird, in eine erste Ausblasrichtung A. Die Einstellung der Ausblasrichtung A erfolgt über eine dafür vorgesehene Öffnung OF1 des Radiallüfter-Gehäuses RDLG sowie die Stellung der Enden der Blende BL im Bezug zur Öffnung OF1.

FIG 2B zeigt die drehbar gelagerte Blende BL in einer zweiten Position POS2. In dieser zweiten Position POS2 erfolgt ein Ausblasen der Luft, die dem Radiallüfter RDL zugeführt wird, in eine zweite Ausblasrichtung B über eine dafür vorgesehene Öffnung OF2 des Radiallüfter-Gehäuses RDLG. Die Einstellung der Ausblasrichtung B erfolgt über die dafür vorgesehene Öffnung OF2 des Radiallüfter-Gehäuses RDLG sowie die Stellung der Enden der Blende BL im Bezug zur Öffnung OF2.

FIG 2C zeigt die drehbar gelagerte Blende BL in einer dritten Position POS3. In dieser dritten Position POS3 erfolgt ein Ausblasen der Luft, die dem Radiallüfter RDL zugeführt wird, sowohl in die erste Ausblasrichtung A als auch in die zweite Ausblasrichtung B. Die Einstellung der Ausblasrichtung A bzw. der Ausblasrichtung B erfolgt über die dafür vorgesehenen Öffnungen OF1 bzw. OF2 des Radiallüfter-Gehäuses RDLG sowie die Stellung der Enden der Blende BL im Bezug zu den Öffnungen OF1 bzw. OF2.

Alternativ zu den Öffnungen OF1 bzw. OF2 im Radiallüfter-Gehäuse RDLG können die Öffnungen auch in der Blende BL selbst realisiert bzw. integriert werden.

Die Figuren FIG 2A bis FIG 2B zeigen in ihrer jeweiligen linken Hälfte das Lüfterrad des Radiallüfters sowie dessen Deckel.

Zu sehen sind weiterhin in FIG 2C mögliche Einbauorte eines Antriebs AN, nämlich in der linken oder rechten oberen Ecke des aufgeklappten Radiallüfters.

FIG 2D zeigt ein beispielhaftes Antriebskonzept der drehbar gelagerten Blende BL im Gehäuse des Radiallüfters RDLG.

Zu diesem Zweck weist die Blende BL an ihrem unteren Rand eine Perforierung PER auf, in die - ähnlich zum Transport eines Filmes in einer Kamera - ein Zahnrad eingreifen kann.

Das Zahnrad (hier nicht dargestellt) wird durch den Antrieb AN, der wie vorstehend beschrieben als Stellmotor in einer Ecke des Radiallüfter-Gehäuses RDLG angeordnet ist, angetrieben.

Somit greift der Antrieb AN als Zahnradgetriebe in die Perforierung PER der Blende BL ein und trägt diese Blende BL gleichzeitig.

Alternativ dazu ist es auch möglich, ein Hebelwerk oder ein Kurvengetriebe oder ein Schneckengetriebe als Antrieb AN zu verwenden.

Der modifizierte Lüfter RDL kann vorteilhafterweise in jedes Basisstationsgehäuse durch einfachen Austausch des Lüfters eingebaut werden.

Damit ist es möglich, die erfindungsgemäße Anordnung sowohl in bestehende Basisstationsgehäuse, die vergleichbar mit FIG 3 keine rückführende Klappe aufweisen, als auch in bestehenden Basisstationsgehäuse, die vergleichbar mit FIG 4 eine rückführende Klappe zwischen der Kammer der Rückwand und dem Inneren des Basisstationsgehäuses aufweisen, nachträglich einzubringen.

## Patentansprüche

1. Anordnung zur Klimatisierung von Baugruppen (BG) in einem abgeschlossenen Gehäuse (BS),
- bei dem die Baugruppen (BG) im Inneren des Gehäuses (BS) angeordnet sind,
- bei dem das Gehäuse (BS) einen Lufteinlass (FS) aufweist, über den Luft (ZL) zur Klimatisierung ins Innere des Gehäuses (BS) geführt wird,
- bei dem das Gehäuse (BS) einen Lüfter (RDL) beinhaltet, über den die zur Klimatisierung der Baugruppen (BG) verwendete Luft (ZL) aus dem Inneren des Gehäuses (BS) nach außen (UM) geführt wird,
**dadurch gekennzeichnet,**
- **dass** der Lüfter (RDL) neben einem Lüftereingang (RLI) zumindest zwei Lüfterausgänge (RLO) aufweist, und
- **dass** im Inneren des Lüfters (RDL) eine drehbar gelagerte Blende (BL) angeordnet ist, durch deren variabel einstellbare Position (POS1, POS2, POS3) die über den Lüftereingang (RLI) in den Lüfter (RDL) eingesaugte Luft (ZL) wahlweise über zumindest einen der Lüfterausgänge (RLO) geführt wird.

2. Anordnung nach Anspruch 1, **dadurch gekennzeichnet, dass** der Lüfter als Radiallüfter (RDL) ausgestaltet ist.

3. Anordnung nach Anspruch 1 oder 2, **dadurch gekennzeichnet, dass** die Blende (BL) um eine Längsachse des Lüfters (RDL) drehbar gelagert ist.

4. Anordnung nach einem der vorhergehenden Ansprüche, **dadurch gekennzeichnet, dass** die Blende (BL) eine Perforation (PER) aufweist, in die über ein Antrieb (AN) zum drehen der Blende (BL) eingreift.

5. Anordnung nach einem der vorhergehenden Ansprüche, **dadurch gekennzeichnet, dass** die Blende (BL) als Verschlussblech ausgestaltet ist, deren Enden die zumindest zwei Lüfterausgänge (RLO) zumindest teilweise öffnen bzw. verschließen, so dass beim Lüfter (RDL) variabel einstellbare Ausblasrichtungen (A, B) wählbar sind.

6. Anordnung nach einem der Ansprüche 1 bis 4, **dadurch gekennzeichnet, dass** die Blende (BL) zumindest zwei Öffnungen aufweist, so dass beim Lüfter (RDL) variabel einstellbare Ausblasrichtungen (A, B) durch die Position der Öffnungen zu den Lüfterausgängen (RLO) wählbar sind.

7. Anordnung nach einem der vorhergehenden Ansprüche, **dadurch gekennzeichnet, dass** die Blende (BL) zur Drehung mit einem Zahnradgetriebe oder einem Hebelwerk oder einem Kurvengetriebe oder einem Schneckengetriebe gekoppelt ist.

8. Lüfter zur Verwendung in einer Anordnung nach einem der Ansprüche 1 bis 7,
**dadurch gekennezichnet**
- dass der Lüfter (RDL) neben einem Lüftereingang (RLI) zumindest zwei Lüfterausgänge (RLO) aufweist,
- dass im Inneren des Lüfters (RDL) eine drehbar gelagerte Blende (BL) angeordnet ist,
- dass durch eine einstellbare Position (POS1, POS2, POS3) der Blende (BL) neben einer ersten Ausblasrichtung (A) eine zweite Ausblasrichtung (B) variabel einstellbar ist, so dass die über den Lüftereingang (RDL) in den Lüfter (RDL) eingesaugte Luft (ZL) wahlweise über zumindest einen der Lüfterausgänge (RLO) einstellbar geführt wird.

## Claims

1. Arrangement for the air conditioning of subassemblies (BG) in a closed housing (BS),
- wherein the subassemblies (BG) are arranged in the interior of the housing (BS),
- wherein the housing (BS) has an air intake (FS) via which air conditioning air (ZL) is guided into the interior of the housing (BS),
- wherein the housing (BS) contains a fan (RDL) by means of which the air (ZL) that is used for the air conditioning of the subassemblies (BG) is guided from the interior of the housing (BS) to the outside (UM),
**characterised in that**
- the fan (RDL) has at least two fan outlets (RLO) in addition to a fan inlet (RLI), and
- a rotatably mounted screen (BL) is arranged in the interior of the fan (RDL), wherein the air (ZL) which is sucked into the fan (RDL) via the fan inlet (RLI) is optionally guided via at least one of the fan outlets (RLO) by means of the variably adjustable position (POS1, POS2, POS3) of said screen.

2. Arrangement according to claim 1, **characterised in that** the fan is embodied as a radial fan (RDL).

3. Arrangement according to claim 1 or 2, **characterised in that** the screen (BL) is mounted in such a way that it can be rotated about a longitudinal axis of the fan (RDL).

4. Arrangement according to one of the preceding claims,
**characterised in that** the screen (BL) has a perforation (PER) in which a drive (AN) engages for the purpose of rotating the screen (BL).

5. Arrangement according to one of the preceding claims, **characterised in that** the screen (BL) is embodied as a sealing panel whose ends at least partially open or close the at least two fan outlets (RLO), such that variably adjustable blow directions (A, B) can be selected for the fan (RDL).

6. Arrangement according to one of claims 1 to 4, **characterised in that** the screen (BL) has at least two openings, such that variably adjustable blow directions (A, B) can be selected for the fan (RDL) by means of the position of the openings relative to the fan outlets (RLO).

7. Arrangement according to one of the preceding claims, **characterised in that** the screen (BL) is coupled to a toothed wheel gear or a lever apparatus or a cam gear or a worm gear for the purpose of rotation.

8. Fan for use in an arrangement as claimed in one of claims 1 to 7,
**characterised in that**
- the fan (RDL) has at least two fan outlets (RLO) in addition to a fan inlet (RLI),
- a rotatably mounted screen (BL) is arranged in the interior of the fan (RDL), and
- by virtue of an adjustable position (POS1, POS2, POS3) of the screen (BL), a second blow direction (B) can be variably adjusted in addition to a first blow direction (A), such that the air (ZL) which is sucked into the fan (RDL) via the fan inlet (RLI) is optionally guided via at least one of the fan outlets (RLO) in an adjustable manner.

## Revendications

1. Agencement pour la climatisation de modules (BG) dans un boîtier fermé (BS), dans lequel
- les modules (BG) sont situés à l'intérieur du boîtier (BS),
- le boîtier (BS) comporte une admission d'air (FS) par laquelle de l'air (ZL) entre à l'intérieur du boîtier (BS) aux fins de la climatisation,
- le boîtier (BS) contient un ventilateur (RDL) par l'intermédiaire duquel l'air (ZL) utilisé pour la climatisation des modules (BG) passe de l'intérieur du boîtier (BS) vers l'extérieur (UM),
**caractérisé en ce que**
- le ventilateur (RDL), outre une entrée de ventilateur (RLI), comporte au moins deux sorties de ventilateur (RLO) et
- à l'intérieur du ventilateur (RDL) est située une chicane (BL) logée rotative dont la position (POS1, POS2, POS3) réglable de manière variable permet le passage de l'air (ZL), aspiré dans le ventilateur (RDL) via l'entrée de ventilateur (RLI), par au moins l'une des sorties de ventilateur (RLO) au choix.

2. Agencement selon la revendication 1, **caractérisé en ce que** le ventilateur se présente sous la forme d'un ventilateur radial (RDL).

3. Agencement selon la revendication 1 ou 2, **caractérisé en ce que** la chicane (BL) est logée rotative autour d'un axe longitudinal du ventilateur (RDL).

4. Agencement selon l'une des revendications précédentes, **caractérisé en ce que** la chicane (BL) comporte une perforation (PER) dans laquelle un entraînement (AN) s'engage pour faire tourner la chicane (BL).

5. Agencement selon l'une des revendications précédentes, **caractérisé en ce que** la chicane (BL) se présente sous la forme d'une tôle de fermeture dont les extrémités ouvrent resp. ferment au moins partiellement les au moins deux sorties de ventilateur (RLO) de sorte que des directions de soufflage (A, B) réglables de manière variable peuvent être sélectionnées pour le ventilateur (RDL).

6. Agencement selon l'une des revendications 1 à 4, **caractérisé en ce que** la chicane (BL) comporte au moins deux orifices de sorte que, pour le ventilateur (RDL), des directions de soufflage (A, B) réglables de manière variable peuvent être sélectionnées du fait de la position des orifices par rapport aux sorties de ventilateur (RLO).

7. Agencement selon l'une des revendications précédentes, **caractérisé en ce que** la chicane (BL), aux fins de sa rotation, est couplée à un engrenage ou à un mécanisme à levier ou à un engrenage à came ou à un engrenage à vis sans fin.

8. Ventilateur destiné à être utilisé dans un agencement selon l'une des revendications 1 à 7, **caractérisé en ce que**
- le ventilateur (RDL), outre une entrée de ventilateur (RLI), comporte au moins deux sorties de ventilateur (RLO),
- à l'intérieur du ventilateur (RDL) est située une chicane (BL) logée rotative,
- du fait d'une position (POS1, POS2, POS3) réglable de la chicane (BL), outre une première direction de soufflage (A), une deuxième direction de soufflage (B) peut être réglée de manière variable de sorte que l'air (ZL) aspiré dans le ventilateur (RDL) via l'entrée de ventilateur (RLI) passe de manière réglable par au moins l'une des sorties de ventilateur (RLO) au choix.
